# EUROPÄISCHE PATENTSCHRIFT

(11) **EP 0 491 389 B1**
(45) Veröffentlichungstag und Bekanntmachung des Hinweises auf die Patenterteilung: **01.05.1996**
(21) Anmeldenummer: 91121732.1
(22) Anmeldetag: 18.12.1991
(51) Int. Cl.: H01L 23/051, H01L 23/427

(54) **Leistungshalbleiterbauelement**
Semiconductor power component
Composant semi-conducteur de puissance

(30) Priorität: 19.12.1990 DE 4040753
(43) Veröffentlichungstag der Anmeldung: 24.06.1992
(73) Patentinhaber: SIEMENS AKTIENGESELLSCHAFT, D-80333 München (DE)
(72) Erfinder: Kuhnert, Reinhold, Dr., W-8000 München 19 (DE); Sittig, Roland, Dr., W-3300 Braunschweig (DE)

(56) Entgegenhaltungen:
- EP-A- 0 144 071
- EP-A- 0 246 539
- DE-A- 2 705 476
- DE-A- 2 938 096
- FR-A- 2 090 206

## Beschreibung

Die Erfindung bezieht sich auf ein Leistungshalbleiterbauelement. Ein Bauelement dieser Art ist aus der FR-A-2 090 206 bekannt, wobei das Bauelement einen Halbleiterkörper aufweist, der an beiden Hauptflächen jeweils durch Weichlöten mit einer oberen und einer unteren Substratscheibe verbunden ist und das einen Kunststoffring aufweist, der die Substratscheiben und den Halbleiterkörper vandseitig umschießt.

Ein Bauelement dieser Art ist aus der EP-A-0 242 626 bekannt. Üblicherweise werden solche Bauelemente in ein gasdichtes Gehäuse eingebaut, um sie vor mechanischen Beschädigungen und schädlichen Umwelteinflüssen zu schützen. Dabei müssen sowohl der elektrische Widerstand der entstehenden Anordnung als auch deren thermischer Widerstand möglichst klein gehalten werden, um einen verlustarmen Betrieb und eine effektive Kühlung des Bauelements zu gewährleisten. Der Erfindung liegt die Aufgabe zugrunde, ein Leistungshalbleiterbauelement der eingangs genannten Art anzugeben, dessen elektrische und thermische Eigenschaften gegenüber den herkömmlichen Bauelementen dieser Art verbessert sind. Das wird erfindungsgemäß durch eine Ausbildung nach den Patentansprüchen 1 oder 2 erreicht.

Der mit der Erfindung erzielbare Vorteil liegt insbesondere darin, daß die einzelnen Teile des Bauelements an ihren vom Laststrom durchflossenen miteinander zu verbindenden Flächen durch Drucksintern oder Diffusionsschweißen materialschlüssig zusammengefügt sind. Vergleicht man die gekapselten Ausführungsformen des Leistungshalbleiterbauelements nach der Erfindung mit den b-ekannten Leistungshalbleiterbauelementen in gekapselter Bauweise, so ergibt sich weiterhin der Vorteil einer starken Reduzierung von Kapsel-volumen und Kapselgewicht.

Die Ansprüche 3 und 4 sind auf vorteilhafte Ausgestaltungen und Weiterbildungen der Erfindung gerichtet.

Die Erfindung wird nachfolgend anhand einiger, in der Zeichnung dargestellter Ausführungsbeispiele näher erläutert. Dabei zeigen:
- Figur 1: ein erstes Ausführungsbeispiel mit einer flachen Gehäuseform,
- Figur 2: eine Darstellung zur Erläuterung von Niedertemperaturverbindungsverfahren,
- Figur 3: ein zweites Ausführungsbeispiel mit einer topfartigen Gehäuseform,
- Figur 4: ein drittes Ausführungsbeispiel für eine siedegekühlte Anlage, die
- Figuren 5 und 6: vorteilhafte Ausgestaltungen des ersten Ausführungsbeispiels und die
- Figuren 7 und 8: zwei weitere Ausführungsbeispiele, bei denen das Leistungshalbleiterbauelement steuerbar ausgebildet ist.

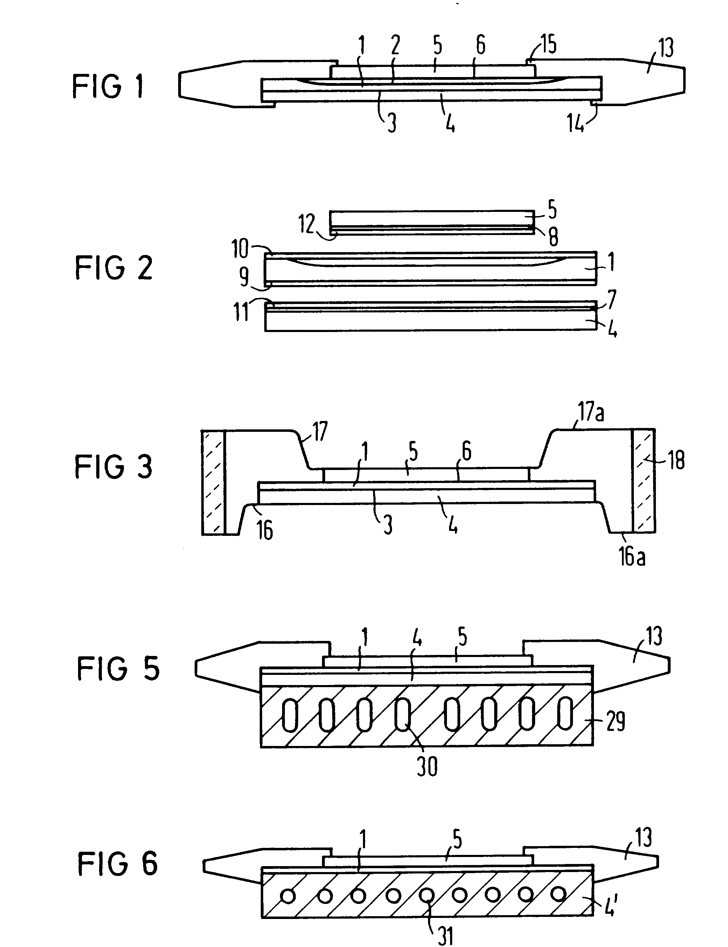

In Figur 1 ist eine großflächige Halbleiterdiode mit einem scheibenförmigen Halbleiterkörper 1 aus dotiertem Halbleitermaterial, z.B. Silizium, dargestellt, der einen planaren pn-Übergang 2 enthält. Das unterhalb des pn-Übergangs 2 liegende Halbleitergebiet ist dabei n-leitend, während das Halbleitergebiet oberhalb von 2 p-leitend ist. Der Halbleiterkörper 1 ist an seiner kathodenseitigen Hauptfläche 3 mit einer Substratscheibe 4 verbunden, die beispielsweise aus Molybdän besteht. Weiterhin ist eine vorzugsweise ebenfalls aus Molybdän bestehende Substratscheibe 5 an seiner anodenseitigen Hauptfläche 6 angefügt.

Die Verbindung der Teile 1, 4 und 5 erfolgt wie bereits erwähnt nach denen an sich bekannten, als Drucksintern bzw. Diffusionsschweißen bezeichneten Verfahren der Niedertemperaturverbindungstechnik. Das Drucksintern wird anhand von Figur 2 näher erläutert. Dabei werden die Substratscheiben 4 und 5 entweder an ihren mit dem Halbleiterkörper 1 zu verbindenden Oberflächen oder auch allseitig mit galvanisch aufgetragenen Kontaktschichten 7 bzw. 8 versehen, die etwa 2 bis 3 µm dick sind und z.B. aus Silber bestehen. Die Oberseite und die Unterseite des Halbleiterkörpers 1 werden jeweils mit einer Schichtfolge überzogen, die aus einer etwa 1 µm starken Al-Schicht, einer auf dieser aufgetragenen, etwa 100 nm dicken Titanschicht, einer über dieser liegenden, etwa 500 nm dicken Mittelschicht, z.B. aus Nickel oder Platin, und schließlich einer diese abdeckenden, etwa 200 nm starken Silberschicht besteht. In Figur 2 sind lediglich die als Kontaktierungsschichten dienenden Silberschichten dargestellt und mit 9 und 10 bezeichnet. Anschließend wird auf den Kontaktierungsschichten 7 und 8 jeweils eine Paste 11 und 12 schichtförmig, und zwar mit einer Schichtdicke von etwa 10 bis 100 µm, vorzugsweise etwa 20 µm, aufgetragen. Als Ausgangsstoff für die Herstellung der Paste 11, 12 wird Silberpulver mit plättchenförmigen Pulverpartikeln verwendet, das in Cyclohexanol als Lösungsmittel suspendiert wird. Anschließend wird die so hergestellte Paste im Vakuum entgast, um beim Trocknen eine Lunkerbildung zu vermeiden.

Nach dem Trocknen der Pasten 11 und 12 werden der Halbleiterkörper 1 mit seiner Kontaktierungsschicht 9 auf die von der Paste 11 bedeckte Oberseite der Substratscheibe 4 und die Substratscheibe 5 mit ihrer von der Paste 12 bedeckten Unterseite auf die Kontaktierungsschicht 10 des Halbleiterkörpers 1 aufgesetzt und die gesamte aus den Teilen 1, 4 und 5 bestehende Anordnung auf eine Sintertemperatur von z.B. 230°C gebracht. Bei dieser Temperatur wird auf die Anordnung 1, 4, 5 während einer Sinterzeit von etwa einer Minute ein Druck von mindestens von 900 N/cm ausgeübt. Es ist jedoch darauf hinzuweisen, daß bereits bei Sinterzeiten von einigen Sekunden eine ausreichende Verbindung der genannten Teile erreicht wird und daß der Druck auch auf 1 bis 2 t/cm gesteigert werden kann. Die Sintertemperatur kann in einem Bereich liegen, der einen unteren Grenzwert von etwa 150°C und einen oberen Grenzwert von etwa 250°C aufweist. Weiterhin ist hervorzuheben, daß das Drucksintern in normaler Atmosphäre vorgenommen wird, d.h. eine Anwendung von Schutzgas nicht erforderlich ist.

Ein weiteres, für die Verbindung der Teile 1, 4 und 5 geeignetes Verfahren der Niedertemperaturverbindungstechnik ist das Diffusionsschweißen. Dabei werden die Substratscheiben 4 und 5 gemäß Figur 2 mit Kontaktschichten 7 und 8 versehen, während auf die Unterseite und die Oberseite des Halbleiterkörpers 1 Edelmetall-Kontaktierungsschichten 9 und 10 aufgebracht werden, die vorzugsweise aus Gold oder Silber bestehen. Es ist vorteilhaft, unter den Kontaktierungsschichten 9 und 10 noch metallische Zwischenschichten, z. B. aus Al, Ag, Cu oder Au, mit einer Schichtdicke von etwa 10 bis 20 µm vorzusehen. Diese Zwischenschichten sind plastisch verformbar, um die Rauhtiefen der miteinander zu verbindenden Flächen auszugleichen. Falls die Zwischenschichten aus Edelmetall bestehen, können die Kontaktierungsschichten 9 und 10 auch entfallen, da sie in diesem Fall durch die Zwischenschichten ersetzt werden. Die in dieser Weise beschichteten Teile 1, 4 und 5 werden nun so aufeinander gesetzt, daß die Unterseite des Halbleiterköpers 1 die Kontaktierungsschicht 7 der Substratscheibe 4 berührt und die Oberseite von 1 der Kontaktierungsschicht 8 der Substratscheibe 5 anliegt. Anschließend werden die Teile 1, 4 und 5 auf eine Temperatur gebracht, die etwa im Bereich von 150 bis 250°C liegt, also in einem gemäßigten Temperaturbereich, der mit der Betriebstemperatur eines Leistungshalbleiters vergleichbar ist. Dabei werden diese Teile mit einem Anpreßdruck von etwa 500 bis 2500 kp/cm oder darüber während einer Diffusionszeit von einigen Minuten zusammengepreßt. Aber auch bei Diffusionszeiten von nur wenigen Sekunden werden schon ausreichende Ergebnisse erzielt. Andererseits kann der Druck auf über 2,5 t/cm gesteigert werden. Auch das Diffusionsschweißen erfolgt zweckmäßigerweise in einer normalen Atmosphäre ohne die Anwendung eines Schutzgases.

Jedes der vorstehend beschriebenen Verbindungsverfahren kann dazu benutzt werden, um zunächst eine Verbindung der Teile 1 und 4 herzustellen, wobei sich dann ein weiteres solches Verfahren anschließt, um die entstandene Anordnung 1, 4 mit der Substratscheibe 5 zu verbinden.

Die miteinander verbundenen Teile 1, 4 und 5 werden anschliessend mit einem z.B. aus aushärtbarem Kunststoff bestehenden Kunststoffmantel 13 (Figur 1) versehen, der die Ränder der Substratscheiben 4 und 5 miteinander verbindet und sie bei 14 und 15 geringfügig seitlich umschließt. Die Substratscheiben 4 und 5 bilden die leitenden Außenwände eines das Halbleiterbauelement umgebenden Gehäuses, das durch den Kunststoffmantel 13 so weit ergänzt wird, daß es nach außen vollständig abgeschlossen ist. Die elektrischen und thermischen Eigenschaften des Bauelements werden gegenüber den herkömmlichen Bauelementen vergleichbarer Art erheblich verbessert, wobei Volumen und Gewicht des Gehäuses bzw. der Kapsel erheblich reduziert werden.

Für ein nach der Erfindung ausgebildetes Leistungshalbleiterbauelement ist es vorteilhaft, den thermischen Ausdehnungskoeffizienten der Substratscheiben 4 und 5 sowie die Verbindungstemperatur so einzustellen, daß zwischen der niedrigsten Betriebstemperatur und der Verbindungstemperatur keine das Bauelement zerstörenden mechanischen Spannungen auftreten können. Durch die Anwendung der erwähnten Verfahren der Niedertemperaturverbindungstechnik und durch eine geeignete Wahl des Substratmaterials, das z.B. aus Mo, W oder einem Cu/Mo-Sinter-werkstoff bestehen kann, wird dies erreicht.

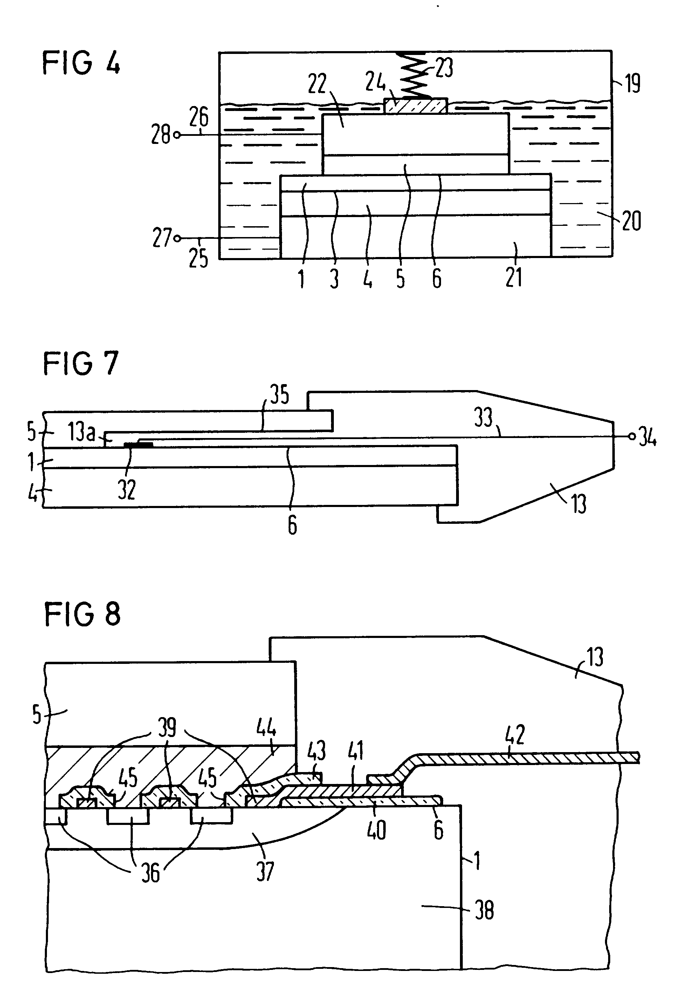

Das Ausführungsbeispiel nach Figur 3 ist nicht Bestandteil der beanspruchten Erfindung und zeigt ein topfartig geformtes Gehäuse für ein Leistungshalbleiterbauelement 1, das, wie bereits beschrieben, mit zwei Substratscheiben 4 und 5 verbunden ist. Mit 16 ist ein metallischer Gehäuseboden bezeichnet, der einen vorgewölbten Rand 16a aufweist und mit der Unterseite der Substratscheibe 4 verbunden ist. Zur Herstellung dieser Verbindung kann zweckmäßigerweise eines der erwähnten Niedertemperaturverbindungsverfahren herangezogen werden. Ein metallischer Gehäusedeckel 17, der ebenfalls einen vorgewölbten Rand 17a hat, ist mit der Substratscheibe 5 verbunden, wobei auch hierzu ein Niedertemperaturverbindungsverfahren verwendet werden kann. Mit besonderem Vorteil werden alle Verbindungen zwischen den Teilen 1, 4, 5, 16 und 17 in ein und demselben Arbeitsgang hergestellt. Zwischen den einander gegenüberstehenden Rändern 16a und 17a ist ein elektrisch isolierender, hohlzylinderförmiger Gehäusemantel 18, z.B. aus Keramik, angeordnet. Die Höhe des Gehäusemantels wird so groß bemessen, daß die erforderliche Sicherheit gegen Überspannungen an der Anoden-Kathoden-Strecke des Bauelements gewährleistet ist.

Figur 4 zeigt ein Ausführungsbeispiel der Erfindung, das in einer siedegekühlten Anlage eingesetzt ist. Diese besteht im wesentlichen aus einem geschlossenen Behälter 19, der teilweise mit einem flüssigen, elektrischen isolierenden Medium 20 gefüllt ist. Hierfür eignet sich beispielsweise Freon. Der scheibenförmige Halbleiterkörper 1 bildet mit den Substratscheiben 4 und 5, die mit ihm in der beschriebenen Weise materialschlüssig verbunden sind, eine bauliche Einheit, die im Behälter 19 derart angeordnet ist, daß sie vom Medium 20 umgeben ist. Damit übernimmtdas isolierende Medium 20 die Funktion des in Figur 1 vorhandenen, Kunststoffmantels 13 und ergänzt die Teile 1, 4 und 5 zu einem nach außen abgeschlossenen, gegen schädliche Umwelteinflüsse geschützten System. Die elektrische Beschaltung des Leistungshalbleiterbauelements 1, 4, 5 erfolgt über zwei Druckkontaktstücke 21 und 22, die jeweils mit den Substratscheiben 4 und 5 in Kontakt stehen und mit einem hinreichenden Kontaktdruck gegeneinandergepreßt werden, was in Figur 4 durch eine Druckfeder 23 angedeutet wird. Eine elektrisch isolierende Scheibe 24 verhindert, daß der im allgemeinen metallische Behälter 19 die Druckkontaktstücke 21 und 22 kurzschließt. Die Druckkontaktstücke 21 und 22 sind jeweils mit elektrischen Zuleitungen 25 und 26 verbunden, die durch die Wandung des Behälters 19 isoliert nach außen geführt sind. Stellen die Teile 1, 4 und 5 wie beschrieben eine Diode dar, so bilden die Anschlüsse 27 und 28 der Zuleitungen 25 und 26 jeweils den kathodenseitigen und anodenseitigen Diodenanschluß. Das in Figur 4 angewandte Kühlungs-prinzip sieht vor, daß die von dem Halbleiterkörper 1 im Betrieb desselben an das Medium 20 abgegebene Wärme dazu führt, daß das letztere teilweise verdampft, wobei die im oberen Teil des Behälters 19 vorhandenen gasförmigen Teile des Mediums 20 an der von außen gekühlten Wandung des Behälters 19 kondensieren und wieder zum unteren Teil von 19 zurückfließen.

In Figur 4 können auch mehrere, jeweils aus den Teilen 1, 4, 5 bestehende, bauliche Einheiten gestapelt und zwischen den Kontaktstücken 21 und 22 angeordnet werden.

In Figur 5 ist eine Ausgestaltung des Ausführungsbeispiels nach Figur 1 dargestellt, bei der ein Kühlelement 29 durch Drucksintern oder Diffusionsschweißen materialschlüssig mit der Substratscheibe 4 verbunden ist, wobei diese Verbindung vorzugsweise gleichzeitig mit den übrigen Verbindungen hergestellt wird. Das Kühlelement 29 ist mit etwa parallel zur Halbleiterscheibe 1 verlaufenden Bohrungen 30 versehen, die zur besseren Wärmeableitung in an sich bekannter Weise von einem Kühlmittel durchströmt werden. Eine weitere in Figur 6 gezeigte Ausgestaltung des Ausführungsbeispiels nach Figur 1 besteht darin, daß die mit der Unterseite des Halbleiterkörpers 1 verbundene Substratscheibe 4' selbst als Kühlelement ausgebildet ist. In diesem Fall ist sie zweckmäßig mit Bohrungen 31 versehen, durch die ein Kühlmittel gepumpt wird.

In Figur 7 stellt 1 den Halbleiterkörper eines steuerbaren Leistungshalbleiterbauelements, z.B. eines Thyristors, dar, der eine Steuerelektrode 32 aufweist. Diese ist mit einer Steuerleitung 33 verbunden, deren Anschluß mit 34 bezeichnet ist. Die Teile 32 und 33 sind in einer Ausnehmung 35 der Substratscheibe 5 angeordnet, wobei ein Ansatz 13a des Kunststoffmantels 13 zweckmäßigerweise die Ausnehmung 35 so ausfüllt, daß er die Steuerleitung 33 gegenüber der Substratscheibe 5 und gegenüber der Hauptfläche 6 des Halbleiterkörpers 1 außerhalb der Steuerelektrode 32 elektrisch isoliert. Anstelle der elektrischen Steuerleitung 33 kann bei einem lichtzündbaren Thyristor auch ein Lichtleiter vorgesehen sein, der zu einem anstelle der Steuerelektrode 32 vorgesehenen, lichtempfindlichen Bereich des Halbleiterkörpers 1 hin verläuft.

Figur 8 zeigt einen Teil eines nach der Erfindung ausgebildeten Thyristors, dessen Halbleiterkörper 1 einen n-Emitter 36 , eine p-Basis 37 und eine n-Basis 38 enthält. Der untere Teil von 1, der den p-Emitter enthält, wurde aus Gründen einer übersichtlichen Darstellung weggelassen. Hier ist eine verfingerte Steuerelektrode 39 vorgesehen, die die p-Basis 37 kontaktiert und mit einem randseitigen, durch eine elektrisch isolierende Schicht 40 vom Halbleiterkörper 1 getrennten Kontakt 41 verbunden ist. Dieser ist seinerseits mit einer Steuerleitung 42 verbunden, die durch den Kunststoffmantel 13 nach außen geführt ist. Die zu einer ersten Metallisierung, z.B. aus Aluminium, gehörenden Teile 39 und 41 werden von einer isolierenden Zwischenschicht 43 abgedeckt. Auf der Zwischenschicht 43 ist eine zweite Metallisierung 44, z.B. aus Aluminium, angeordnet, die den n-Emitter 36 jeweils in Kontaktlöchern 45 der Zwischenschicht 43 kontaktiert und mit der Substratscheibe 5 verbunden ist. Auch die Verbindung erfolgt durch Anwendung eines Niedertemperaturverbindungsverfahrens, wie es weiter oben beschrieben wurde. Durch eine solche Zweilagenmetallisierung 39 und 44 in Verbindung mit einem randseitigen Kontakt 41 kann eine elektrische Ansteuerung bestimmter Halbleiterbereiche in der Hauptfläche 6 des Halbleiterkörpers 1 auch ohne die in Figur 7 angedeutete Ausnehmung 35 der Substratscheibe 5 erfolgen.

Außer den dargestellten können auch andere scheibenförmige Halbleiterbauelemente, wie z.B. Transistoren oder Vierschicht-dioden, mit Substratscheiben materialschlüssig verbunden und sodann mit einem Kunststoff- oder Keramikmantel umgeben oder in einer siedegekühlten Anlage angeordnet werden. In allen diesen Fällen führt die materialschlüssige Verbindung der vom Laststrom durchflossenen Flächen der einzelnen Bauelementeteile zu einer wesentlichen Verbesserung der thermischen und elektrischen Eigenschaften der Bauelemente.

## Patentansprüche

1. Leistungshalbleiterbauelement mit einem scheibenförmigen Halbleiterkörper (1) aus dotiertem Halbleitermaterial, der an seiner ersten Hauptfläche (3) durch Drucksintern oder Diffusionsschweißen mit einer ersten Substratscheibe (4) verbunden ist, bei dem der Halbleiterkörper (1) an seiner zweiten Hauptfläche (6) durch Drucksintern oder Diffusionsschweißen mit einer zweiten Substratscheibe (5) verbunden ist, bei dem die aus dem Halbleiterkörper (1) und den Substratscheiben bestehende Einheit (1, 4, 5) in einem teilweise mit einem flüssigen, elektrisch isolierenden Medium (20) gefüllten, geschlossenen Behälter (19) einer siedegekühlten Anlage so angeordnet ist, daß sie von diesem Medium (20) umgeben ist und bei dem die von dem flüssigen, elektrisch isolierenden Medium (20) umgebene Einheit eine Mehrzahl von aufeinander gestapelten, jeweils beidseitig mit Substratscheiben (4, 5) verbundenen Halbleiterkörpern (1) enthält.

2. Leistungshalbleiterbauelement mit einem scheibenförmigen Halbleiterkörper (1) aus dotiertem Halbleitermaterial, der an seiner ersten Hauptfläche (3) durch Drucksintern oder Diffusionsschweißen mit einer ersten Substratscheibe (4') verbunden ist, bei dem der Halbleiterkörper (1) an seiner zweiten Hauptfläche (6) durch Drucksintern oder Diffusionsschweißen mit einer zweiten Substratscheibe (5) verbunden ist, bei dem ein die Ränder beider Substratscheiben (4', 5) miteinander verbindender Kunststoffmantel (13) vorgesehen ist, der zusammen mit beiden Substratscheiben (4', 5) ein den Halbleiterkörper (1) nach außen vollständig abschließendes Gehäuse bildet, und bei dem die erste Substratscheibe (4') selbst als Kühlelement ausgebildet ist und mit etwa parallel zur Halbleiterscheibe verlaufenden, von einem Kühlmittel durchströmten Bohrungen (31) versehen ist.

3. Leistunghalbleiterbauelement nach Anspruch 1 oder 2, **dadurch gekennzeichnet**, daß der Halbleiterkörper (1) ein steuerbares Halbleiterbauelement aufweist, dessen Steuerelektrode (32) oder dessen lichtempfindlicher Bereich in einer Ausnehmung (35) der zweiten Substratscheibe (5) angeordnet und mit einer gegen den Halbleiterkörper (1) und die zweite Substratscheibe (5) isoliert angeordneten Steuerleitung (33) versehen ist.

4. Leistunghalbleiterbauelement nach Anspruch 1 oder 2, **dadurch gekennzeichnet**, daß der Halbleiterkörper (1) ein steuerbares Halbleiterbauelement aufweist, dessen Steuerelektrode (39) über eine erste Metallisierung mit einem am Rand des Halbleiterkörpers (1) angeordneten Kontakt (41) verbunden ist, der mit einer Steuerleitung (42) beschaltet ist, und daß eine zweite Metallisierung vorgesehen ist, die einzelne Gebiete (36) des Halbleiterkörpers (1) kontaktiert und mit der zweiten Substratscheibe (5) durch Drucksintern oder Diffusionsschweißen verbunden ist.

## Claims

1. Power semiconductor component having a semiconductor body (1) which is in the form of a wafer, is made of doped semiconductor material and is connected, at its first main area (3), to a first substrate wafer (4) by means of pressure sintering or diffusion welding, in which the semiconductor body (1) is connected, at its second main area (3), to a second substrate wafer (5) by means of pressure sintering or diffusion welding, in which the unit (1, 4, 5) comprising the semiconductor body (1) and the substrate wafers is arranged in a closed container (19) of an evaporatively cooled installation, which container is partially filled with a liquid, electrically insulating medium (20), in such a way that the said unit is surrounded by the said medium (20), and in which the unit surrounded by the liquid, electrically insulating medium (20) contains a plurality of semiconductor bodies (1) which are stacked one on the other and are each connected on both sides to substrate wafers (4, 5).

2. Power semiconductor component having a semiconductor body (1) which is in the form of a wafer, is made of doped semiconductor material and is connected, at its first main area (3), to a first substrate wafer (4') by means of pressure sintering or diffusion welding, in which the semiconductor body (1) is connected, at its second main area (6), to a second substrate wafer (5) by means of pressure sintering or diffusion welding, in which there is provided a plastic sheath (13) which connects the edges of the two substrate wafers (4', 5) to one another and, together with the two substrate wafers (4', 5), forms a housing which completely seals the semiconductor body (1) from the outside, and in which the first substrate wafer (4') itself is designed as a cooling element and is provided with bores (31) which run approximately parallel to the semiconductor wafer and through which coolant flows.

3. Power semiconductor component according to Claim 1 or 2, characterized in that the semiconductor body (1) has a controllable semiconductor component, the control electrode (2) or light-sensitive region of which is arranged in a recess (35) in the second substrate wafer (5) and is provided with a control line (33) which is arranged in a manner insulated from the semiconductor body (1) and the second substrate wafer (5).

4. Power semiconductor component according to Claim 1 or 2, characterized in that the semiconductor body (1) has a controllable semiconductor component, the control electrode (39) of which is connected via a first metallization layer to a contact (41) which is arranged on the edge of the semiconductor body (1) and is wired up to a control line (42), and in that a second metallization layer is provided, which makes contact with individual regions (36) of the semiconductor body (1) and is connected to the second substrate wafer (5) by means of pressure sintering or diffusion welding.

## Revendications

1. Composant semi-conducteur de puissance, comportant un corps semi-conducteur (1) en forme de plaque en matière semi-conductrice dopée, qui est relié au niveau de sa première surface principale (3), par frittage sous pression ou soudage par diffusion, à une première plaquette de substrat (4), le corps semi-conducteur (1) étant relié au niveau de sa deuxième surface principale (6), par frittage sous pression ou soudage par diffusion, à une deuxième plaquette de substrat (5), l'ensemble (1, 4, 5) constitué du corps semi-conducteur (1) et des plaquettes de substrat étant disposé dans un récipient (19) d'une installation refroidie par évaporation, fermé, rempli partiellement d'un fluide (20) à isolation électrique de manière à être entouré de ce fluide (20), et l'ensemble entouré du fluide (20) à isolation électrique comportant une pluralité de corps semi-conducteurs empilés les uns sur les autres et reliés à chaque fois des deux côtés à des plaquettes de substrat (4, 5).

2. Composant semi-conducteur de puissance, comportant un corps semi-conducteur (1) en forme de plaque en matière semi-conductrice dopée, qui est relié au niveau de sa première surface principale (3), par frittage sous pression ou soudage par diffusion, à une première plaquette de substrat (4'), le corps semi-conducteur (1) étant relié au niveau de sa deuxième surface principale (6), par frittage sous pression ou soudage par diffusion, à une deuxième plaquette de substrat (5), une gaine plastique (13) reliant entre eux les bords des deux plaquettes de substrat (4', 5) étant prévue, qui, ensemble avec les deux plaquettes de substrat (4', 5), constitue un bâti isolant le corps semi-conducteur (1) complètement vers l'extérieur, et la première plaquette de substrat (4') étant réalisée elle-même sous forme d'élément réfrigérant et étant pourvue de perçages (31) s'étendant sensiblement parallèlement à la plaque semi-conductrice, dans lesquels passe un produit réfrigérant.

3. Composant semi-conducteur de puissance selon l'une des revendications 1 ou 2, caractérisé en ce que le corps semi-conducteur (1) comporte un composant semi-conducteur commandable dont l'électrode de commande ou dont la zone sensible à la lumière est disposée dans un creux (35) de la deuxième plaquette de substrat (5) et est pourvue d'une ligne de commande (33) disposée de manière à être isolée contre le corps semi-conducteur (1) et la deuxième plaquette de substrat (5).

4. Composant semi-conducteur de puissance selon l'une des revendications 1 ou 2, caractérisé en ce que le corps semi-conducteur (1) comporte un composant semi-conducteur commandable dont l'électrode de commande (39) est reliée par l'intermédiaire d'une première métallisation à un contact (41) disposé au bord du corps semi-conducteur (1), qui peut être commandé par une ligne de commande (42) et en ce qu'une deuxième métallisation est prévue qui touche des régions (36) individuelles du corps semi-conducteur (1) et qui est reliée à la deuxième plaquette de substrat (5) par frittage sous pression ou soudage par diffusion.
